Europäisches Patentamt

European Patent Office

Office européen des brevets

(19)

(11) **EP 0 779 632 B1**

(12) **FASCICULE DE BREVET EUROPEEN**

(45) Date de publication et mention
de la délivrance du brevet:
**11.09.2002 Bulletin 2002/37**

(51) Int Cl.[7]: **H01F 10/08**, G01R 33/09,
G11B 5/39, H01L 43/10

(21) Numéro de dépôt: **96402718.9**

(22) Date de dépôt: **12.12.1996**

(54) **Structure et capteur multicouches et procédé de réalisation**

Mehrschichtstruktur und Sensor sowie Herstellungsverfahren

Multilayer structure and sensor and fabrication process

(84) Etats contractants désignés:
**CH DE GB LI NL**

(30) Priorité: **15.12.1995 FR 9514898**

(43) Date de publication de la demande:
**18.06.1997 Bulletin 1997/25**

(73) Titulaire: **COMMISSARIAT A L'ENERGIE
ATOMIQUE
75015 Paris (FR)**

(72) Inventeurs:
• **Dieny, Bernard**
**38170 Seyssinet (FR)**
• **Auffret, Stéphane**
**38410 Vaulnaveys-Le-Haut (FR)**
• **Cowache, Christophe**
**38170 Seyssinet (FR)**
• **Berthet, Franck**
**38170 Seyssinet (FR)**

(74) Mandataire: **Dubois-Chabert, Guy et al
BREVATOME
3, rue du Docteur Lanceraux
75008 Paris (FR)**

(56) Documents cités:
• **PATENT ABSTRACTS OF JAPAN vol. 017, no.
383 (E-1400), 19 Juillet 1993 & JP 05 067525 A
(TDK CORP), 19 Mars 1993,**
• **JOURNAL OF MAGNETISM AND MAGNETIC
MATERIALS, vol. 140/144, no. PART 01, 1 Février
1995, page 495/496 XP000490388 STEREN L B ET
AL: "GIANT MAGNETORESISTANCE IN HYBRID
MAGNETIC NANOSTRUCTURES"**
• **JOURNAL OF CRYSTAL GROWTH, vol. 111, no.
1 / 04, 2 Mai 1991, pages 1003-1010, XP000298483
ETIENNE P ET AL: "MOLECULAR BEAM
EPITAXIAL GROWTH OF CR/FE,AG/FE,AG/CR
AND AG/CO SUPERLATTICES ON MGO (001)
SUBSTRATES"**
• **JOURNAL OF MAGNETISM AND MAGNETIC
MATERIALS, vol. 140/144, no. PART 01, 1 Février
1995, page 609/610 XP000490423 ALPHEN VAN
E A M ET AL: "INFLUENCE OF ANNEALING ON
THE STRUCTURAL AND MAGNETIC
PROPERTIES OF CO/AG MULTILAYERS WITH
THIN CO LAYERS"**
• **R.M. Bozorth: "Ferromagnetism", 1959, pp. 94 -
101, Van Nostrand Company, Princeton (US)**

## Description

Domaine technique

La présente invention concerne globalement les détecteurs de champs ou de flux magnétiques, et plus particulièrement les capteurs magnétorésistifs. Ces derniers sont par exemple utilisés dans l'enregistrement magnétique, pour lire l'information inscrite sur un support magnétique de stockage de l'information. De façon plus générale, le type de microcapteur décrit dans la présente invention concerne la détection de faibles champs magnétiques (typiquement dans la gamme 0,1 Oe à quelques 10 Oe, c'est-à-dire de quelques A/m à quelques milliers d'A/m). Comme autres exemples d'application, on peut citer la détermination du courant électrique circulant dans un conducteurs à partir de la mesure du champ magnétique régnant dans le voisinage de ce conducteurs, les capteurs de position (translation ou rotation) ou les boussoles magnétorésistives.

Etat de la technique

Jusqu'en 1990, les capteurs magnétorésistifs utilisés pour la détection des faibles champs magnétiques, notamment dans le domaine de l'enregistrement magnétique, étaient basés sur l'effet d'anisotropie de la magnétorésistance. Une description détaillée de cet effet se trouve dans l'article de D.A. Thompson et al., IEEE Trans. Mag. Mag-11, p. 1039 (1975). Cet effet, présent dans les métaux de transition ferromagnétiques (alliages à base de Ni, Co, Fe), consiste en une variation de la résistivité du matériau magnétique en fonction de l'angle entre le courant de mesure circulant dans l'élément magnétorésistif et l'aimantation du matériau. Le changement relatif de résistivité du matériau magnétique $(\Delta\rho/\rho)$ peut atteindre 4 à 5% à température ambiante, dans des champs de l'ordre du kA/m, dans les métaux de transition ferromagnétiques massifs. Cette amplitude est néanmoins réduite à 1 ou 2%, lorsque les mêmes matériaux sont déposés en couches minces de l'ordre de 15 à 30 nanomètres d'épaisseur. Ce domaine d'épaisseur est celui utilisé dans les capteurs magnétorésistifs actuels. La sensibilité de ces capteurs est donc limitée. Par ailleurs, leur réponse n'est pas linéaire du fait que la variation de résistivité est proportionnelle au carré du cosinus de l'angle entre le courant et l'aimantation.

En 1989, des effets de magnétorésistance géante ont été découverts dans des multicouches (Fe 3nm/Cr 0,9nm)$_n$ et par la suite dans de nombreux autres systèmes en multicouches formés d'une alternance de couches de métal de transition ferromagnétique et de couches de métal non-magnétique.

Le document PATENT ABSTRACT OF JAPAN, vol. 017, n°383 (E-1400), 19 juillet 1993 & JP-A-5 67525 (TDK CORP), 19 mars 1993 décrit une alternance de couches minces magnétiques contenant au moins un des éléments parmi Fe, Co, Ni, Ag, ces couches minces étant déposées sur une couche tampon 1 comportant au moins l'un des éléments Ag, Au, Cu.

Selon l'exemple donné, la couche tampon 1 est en argent, d'épaisseur 73,9 nanomètres, et la structure multicouche 2 est formée de couches alternées de Co (épaisseur 0,6 nm) et d'Ag (épaisseur 2,1 nm).

Le Journal of Crystal Growth, vol. 111, n°1/04, 2 mai 1991, pages 1003-1010, XP000298493, Etienne P. et al. : "Molecular Beam Epitaxial Growth of Cr/Fe, Ag/Fe, Ag/Cr and Ag/Co superlattices on MgO (001) Substrates", mentionne l'utilisation du couple Ag-Co pour les effets de magnétorésistance (page 1008, colonne 1, deuxième paragraphe). Il mentionne également une structure dans laquelle une couche d'argent est interposée entre un substrat MgO et une couche Co.

"Un Article du "JOURNAL OF MAGNETISM AND MAGNETIC MATERIALS, vol. 140/144, n° PART 01, 1 février 1995, pp. 495/496 (STEREN L.B. et al.)" décrit un matériau comportant un empilement alterné :

- de couches NiFe,
- de couches Ag
- de couches ultraminces de Co.

La couche d'Ag se situe à l'interface entre la couche de cobalt et la couche de NiFe (col. 1, ligne 12 de cet Article)".

Dans ces systèmes, comme expliqué dans l'article de STEREN et Al, l'effet de magnétorésistance est essentiellement lié à un changement dans l'orientation relative des aimantations des couches ferromagnétiques successives. Cet effet est nommé dans la littérature "magnétorésistance géante" ou "effet de vanne de spin" (en anglais "giant magnetoresistance" ou "spin-valve effect"). Des revues sur ces matériaux en multicouche présentant une magnétorésistance géante ont été publiées par H. Yamamoto et T. Shinjo, IEEE Translation Journal on Magnetics in Japan, vol. 7, n°9, Sept 1992 ainsi que par B. Dieny, Journal of Magnetism and Magnetic Materials 136 ( 1994) 335.

Le brevet FR-2 698 965 intitulé "structure et capteur magnétique multicouches à forte magnétorésistance, et procédé de fabrication de la structure " décrit un système en multicouche particulier, à base de couches alternées de Permalloy (alliage à base de Ni et de Fe, de composition voisine de $Ni_{80}Fe_{20}$) d'épaisseur de l'ordre de 1 à 2 nm, et d'Ag (d'épaisseur de 1 à 2 nm). Pour cette épaisseur d'Ag, un couplage antiferromagnétique existe entre les couches de Permalloy à travers les couches d'Ag. Lorsque ce matériau est préparé par pulvérisation cathodique en maintenant le substrat en cours de dépôt à basse température (azote liquide), il présente alors de très bonne propriétés structurales magnétiques et magnétorésistives, qui le rendent particulièrement prometteur pour des applications. En effet, il offre une bonne sensibilité en terme de pente de variation relative de résistance R, en fonction du champ H à mesurer (

$$\dfrac{d\left(\dfrac{\Delta R}{R}\right)}{dH}$$

de l'ordre de 0,1 à 0,2%/Oe), une bonne linéarité de la réponse sur une large gamme de champs à mesurer (de l'ordre de 1 à quelques dizaines d'Oe). De plus, ce matériau offre une bonne stabilité thermique jusqu'à des températures de l'ordre de 250°C du fait de l'immiscibilité du NiFe et de l'Ag. Toutefois, les propriétés du matériau se dégradent si des recuits sont effectués à des températures supérieures à 250°C. Or il peut arriver, dans les procédés technologiques de lithographie utilisés en microélectronique pour la fabrication de microcapteurs de champ magnétique, que le matériau subisse des échauffements au-delà de 250°C (jusqu'à 300°C) pendant plusieurs minutes. Le but de la présente invention est d'améliorer la stabilité thermique du matériau en multicouches et de faire en sorte qu'il conserve des propriétés aussi bonnes, voire meilleures, après exposition à des températures jusqu'à 300°C, que dans l'état brut de dépôt.

Exposé de l'invention

Le problème auquel la présente invention répond est donc d'augmenter autant que possible la stabilité thermique du matériau magnétorésistif constitutif des capteurs magnétorésistifs, tout en conservant une bonne sensibilité du matériau en champs faibles. L'augmentation de la stabilité thermique assure également une meilleure longévité du matériau, et en particulier une meilleure résistance à l'électromigration.

Ainsi, l'invention a pour objet une structure magnétique en couche telle que définie en revendication 1.

L'introduction de la couche interfaciale a pour effet de beaucoup augmenter la stabilité structurale du matériau lorsque celui-ci est soumis à des recuits pouvant aller jusqu'à 300°C pendant 20 minutes. Une comparaison de l'effet d'un recuit à 300°C pendant 20 minutes, sur une multicouche de composition (NiFe 2,5 nm/Ag 1,1 nm)$_{20}$ et (Co 0,2 nm/NiFe 2,5 nm/Co 0,2 nm/ Ag 1,1 nm)$_{20}$ montre que les propriétés magnétorésistives de la première structure (sans Co aux interfaces) se sont beaucoup dégradées au cours du recuit alors que les propriétés magnétorésistives de la seconde ont été conservées. Par ailleurs, l'amplitude de magnétorésistance est aussi augmentée par l'adjonction de la fine couche de Co aux interfaces. Un doublement de l'amplitude de magnétorésistance est observée dans des structures de composition (NiFe 2,5 nm/Ag 1,1 nm)$_{10}$ par l'ajout de 0,25 nm de Co aux interfaces.

De préférence, l'empilement comporte au moins deux couches du premier type et une couche du second type.

Par ailleurs, une couche de Co peut également être introduite de part et d'autre de l'empilement.

L'empilement peut comporter des couches différentes du premier type et/ou des couches différentes du second type.

Par ailleurs, par couche à base de matériaux magnétiques on entend une couche répondant à la formule générique : Ni$_{100-x-y-z}$Co$_x$Fe$_y$A$_z$ où 0≤x<30, 0≤y≤100 et o≤z≤40, et 0≤x+y+z≤100 et A désigne un élément ou un ensemble d'éléments quelconques. A titre d'exemple de matériaux correspondants à cette formule, on peut citer : le permalloy, le mu-métal, le supermalloy, le sundust, ...

Un alliage riche en argent, pour les couches du second type, peut être de formule Ag$_x$Cu$_{1-x}$ ou Ag$_x$Au$_{1-x}$ avec o<x<0,5. A priori, l'argent pur donnera la meilleure stabilité thermique, mais l'adjonction de cuivre ou encore plus sûrement, d'or, permettrait de réduire le champ à saturation du dispositif et donc d'accroître sa sensibilité.

De préférence, la couche interfaciale a une épaisseur comprise entre une fraction de plan atomique et quelques plans atomiques.

L'épaisseur des couches du second type peut être telle qu'un couplage antiferromagnétique existe entre les couches du premier type à travers les couches du second type et les couches interfaciales. L'épaisseur des couches du second type peut être par exemple comprise entre 0,8 et 1,5 nm.

Selon un autre aspect, dans certaines applications, la couche du second type peut être d'une épaisseur telle qu'il n'existe aucun, ou seulement un très faible, couplage antiferromagnétique entre les couches du premier type.

L'invention a également pour objet un procédé de réalisation d'une structure magnétique en couche telle que définie en revendication 13.

Les couches peuvent être déposées par condensation de vapeurs métalliques sur un substrat, à une température inférieure à la température ambiante. Le dépôt peut par exemple être réalisé par pulvérisation cathodique.

L'invention a également pour objet un capteur multicouches à effet magnétorésistif comportant une structure magnétique en couche telle que décrite ci-dessus.

Ainsi, l'invention a aussi pour objet un capteur de courant destiné à mesurer le courant parcourant un conducteur électrique comprenant un ruban magnétorésistif entourant le conducteur et dont les extrémités sont destinées à être connectées à un dispositif de mesure du courant, le ruban étant constitué en structure magnétique en couche telle que décrite ci-dessus.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 représente une structure multicouche selon l'invention,
- les figures 2A et 2B représentent la magnétorésistance d'une multicouche respectivement selon l'art antérieur et selon l'invention,
- les figures 3A et 3B représentent l'évolution de la magnétorésistance en fonction de l'épaisseur de Co,
- la figure 3C représente l'évolution du champ de saturation en fonction de l'épaisseur de Co,
- les figures 4A et 4B représentent l'évolution de la magnétorésistance et du champ magnétique de saturation en fonction de l'épaisseur de la couche d'argent,
- la figure 5 représente schématiquement une application de l'invention à un capteur de courant,
- la figure 6 représente une application de l'invention à une tête magnétique d'écriture et/ou de lecture.

Description détaillée de modes de réalisation

Un premier exemple de structure selon l'invention a pour composition :
substrat/couche tampon/(Py $e_{Py}$/X $e_x$/(Ag $e_{Ag}$/X $e_x$/Py $e_{Py}$/X $e_x)_n$/Ag $e_{Ag}$/X $e_x$/Py $e_{Py}$/couche de couverture.

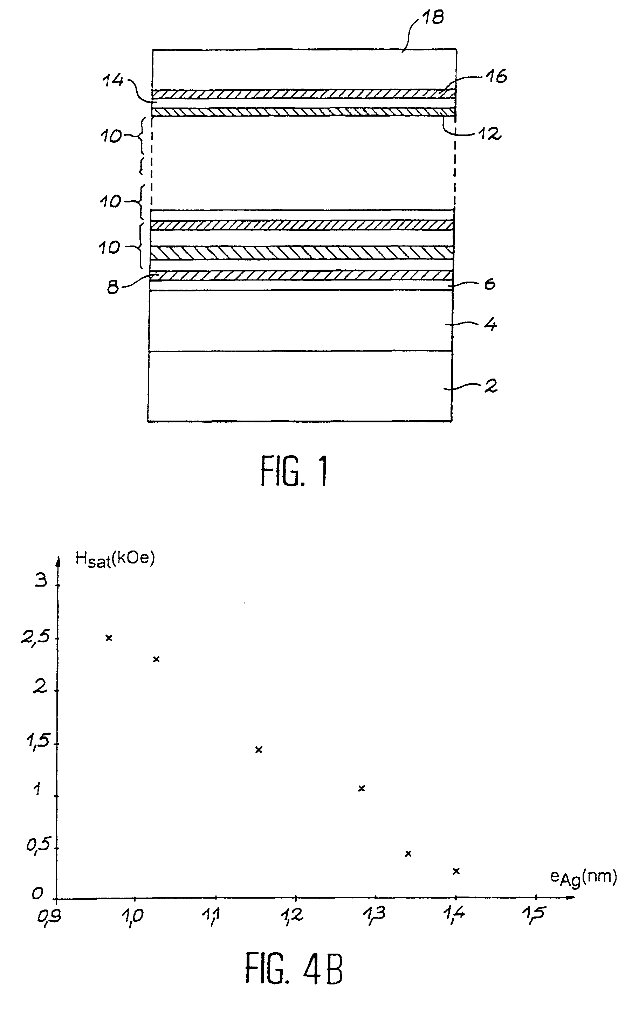

Une telle structure est représentée schématiquement sur la figure 1 où les références 2 et 4 désignent respectivement le substrat et la couche tampon. Les références 6 et 8 désignent respectivement une première couche Py et une couche X encore appelée couche interfaciale. L'ensemble Ag/X/Py/X est désigné globalement par la référence 10. Cet ensemble ou ce motif peut être répété n fois.

Les références 12, 14 et 16 désignent respectivement une dernière couche d'argent, une couche interfaciale X et une dernière couche Py sur laquelle est déposée une couche 18 de couverture.

Le substrat 2 peut être par exemple du Si intrinsèque ou faiblement dopé (pour qu'il ne soit pas trop conducteur par rapport au multicouche, et donc qu'il ne shunte pas le courant), du verre, du Kapton, un oxyde tel que MgO... La couche tampon 4 a pour but d'améliorer la qualité structurale du matériau lors de sa croissance. Elle peut être par exemple en Tantale d'épaisseur de quelques nanomètres (5 nm par exemple).

Py désigne un alliage de la famille d'alliages de composition $Ni_{100-x-y-z}Co_xFe_yA_z$ et préférentiellement un alliage du type Permalloy ou mu-métal. Différentes variétés de Permalloy et mu-métal existent de

composition proche de $Ni_{80}Fe_{20}$ avec possibilité d'addition de troisième ou quatrième élément tel que Co ou Mo. La plupart de ces matériaux se caractérisent par des propriétés magnétiques douces (faible hystérésis (champ coercitif de l'ordre de quelques Oe ou moins), faible champ de saturation (une dizaine d'Oe (800 A/m) ou moins), haute perméabilité (plusieurs centaines), et peuvent entrer dans la structure proposée.

Dans la formule générale $Ni_{100-x-y-z}Co_xFe_yA_z$, x+y+z est compris de préférence entre 0 et 40, x entre 0 et 30, y entre 0 et 30, z entre 0 et 20. A désigne un seul élément ou plusieurs éléments, tels que par exemple Cu, Cr, Mo, V, B qui sont parfois rajoutés comme additifs en faible quantité dans la composition des alliages de haute perméabilité (Permalloy, mu-métal, Supermalloy...). Des exemples de ces alliages sont donnés dans "Introduction to magnetic materials, Cullity, Addison-Wesley Publishing Company, 1972, p. 529, table 13.6).

$e_{Py}$ est l'épaisseur de ces couches de Permalloy (par exemple les couches 8, 16 sur la figure 1). Elle peut varier entre 1 et 20 nm et elle est comprise préférentiellement entre 1,5 et 5 nm. En effet, ces épaisseurs doivent être de l'ordre de grandeur ou inférieures aux libres parcours moyens électroniques dans ces matériaux (lesquels sont de l'ordre de la dizaine de nm). De plus, le maximum de magnétorésistance est observé autour d'une épaisseur de Py de 2,2 nm, la meilleure sensibilité est obtenue pour des épaisseurs supérieures à 6 nm alors que la stabilité thermique se dégrade à partir d'environ 5 nm. C'est pourquoi l'épaisseur de Py sera préférentiellement comprise entre 1,5 et 5 nm.

X désigne la fine couche interfaciale introduite aux interfaces entre le Permalloy et l'Ag (par exemple : les couches 8 et 14 sur la figure 1). X peut être du Co ou un alliage riche en Co (par exemple $Co_{90}Fe_{10}$ ou $Co_{70}Fe_{30}$). $e_X$ est l'épaisseur de cette couche interfaciale. Elle peut varier d'une fraction de plan atomique à quelques plans atomiques (par exemple : 2, 3 ou 4 plans) et elle est préférentiellement d'environ un plan atomique (0,25 nm). Les figures 3B et 3C montrent qu'un plan atomique de Co suffit pour obtenir une augmentation conséquente de la magnétorésistance géante et de la stabilité thermique. Mettre plus d'un plan atomique de Co tend à augmenter relativement sensiblement le champ à saturation et donc à réduire la sensibilité du matériau.

$e_{Ag}$ désigne l'épaisseur des couches d'argent. Cette épaisseur est de préférence telle qu'un couplage antiferromagnétique existe entre les couches de Permalloy à travers les couches d'Ag. Cette condition est satisfaite pour des épaisseurs d'Ag comprises entre 0,9 et 1,3 nm environ.

n désigne le nombre de périodes du multicouche sans compter les couches de Py externes (n peut varier de 0 à toute valeur entière quelconque, mais est typiquement compris entre 0 et 50 pour les applications dans l'enregistrement magnétique).

La couche de couverture 18 sert à éviter l'oxydation de la structure. Elle peut être en Ta par exemple.

Par rapport à la composition proposée ci-dessus, différentes nuances peuvent être apportées. Il est possible, par exemple, d'introduire une fine couche interfaciale entre la couche tampon et la première couche de Py et/ou entre la dernière couche de Py et la couche de couverture, ou alors de commencer par déposer, après la couche tampon, une couche d'Ag ou de finir, avant la couche de couverture, par une couche d'Ag.

Un autre exemple de structure selon l'invention est du type "vanne de spin" à base d'Ag. Les structures vanne de spin simple du type NiFe (6 à 8 nm)/Cu (2 à 4 nm)/NiFe (3 à 6 nm)/FeMn (7 à 12 nm) présentent des propriétés magnétorésistives tout à fait intéressantes pour des applications dans l'enregistrement magnétique. Il en est de même pour les vannes de spin duales telles que NiO (5 à 10 nm)/NiFe (3 à 6 nm)/Cu (2 à 4 nm)/NiFe (6 à 8 nm)/Cu (2 à 4 nm)/NiFe (3 à 6 nm)/FeMn (7 à 12 nm). Le défaut de ces structures est une relativement mauvaise tenue aux recuits, liée à la présence des interfaces NiFe/Cu. En effet, le Permalloy et le Cu étant miscible, ces deux matériaux tendent à interdiffuser, lors des recuits, ce qui conduit à une dégradation des propriétés magnétorésistives.

L'invention concerne donc également une structure vanne de spin ayant pour composition : substrat/couche tampon/Py (5 à 10 nm)/X $e_X$/Ag (2 à 4 nm)/X $e_X$/Py (3 à 6 nm)/couche antiferromagnétique (par exemple FeMn 7 à 12 nm)/couche de couverture. Le substrat, la couche tampon, la couche de couverture, la fine couche interfaciale ont les mêmes caractéristiques que décrites pour la première structure proposée. La couche antiferromagnétique a pour but de piéger par anisotropie d'échange l'aimantation de la couche de Py adjacente.

Une troisième structure selon l'invention, voisine de la deuxième, est une vanne de spin duale, ayant pour composition :
substrat/couche tampon/couche antiferromagnétique (par exemple NiO de 5 à 10 nm)/NiFe (3 à 6 nm)/X $e_X$/Ag (2 à 4 nm)/X $e_X$/NiFe (6 à 8 nm)/X $e_X$/Ag (2 à 4 nm)/X $e_X$/NiFe (3 à 6 nm)/couche antiferromagnétique (par exemple FeMn de 7 à 12 nm)/couche de couverture.

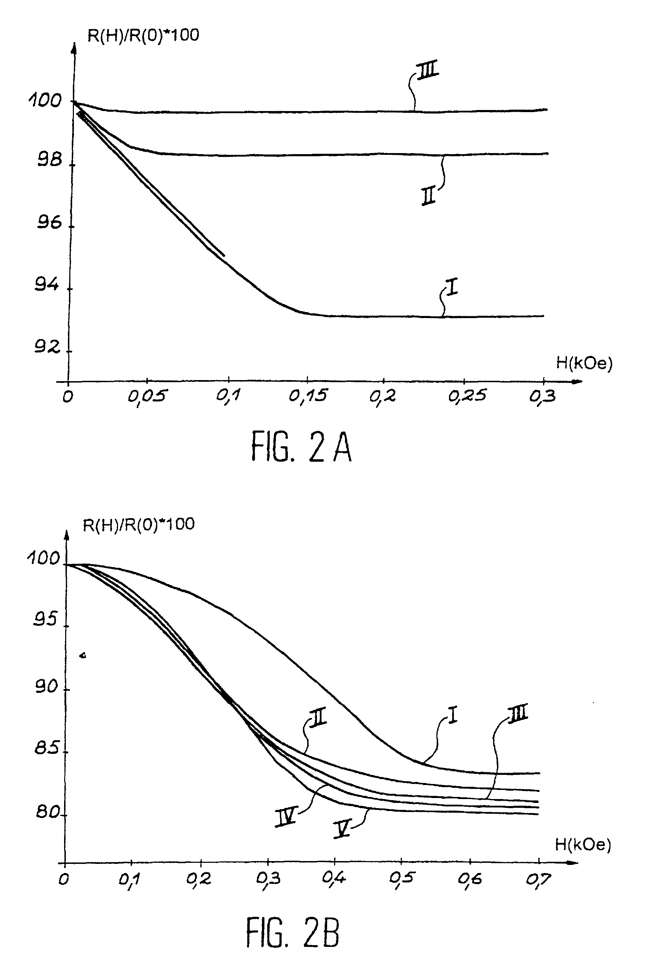

Les figures 2A et 2B illustrent l'augmentation de la stabilité des propriétés de ces structures, lors de recuits entre 250°C et 300°C, liée à l'adjonction des fines couches interfaciales de Co aux interfaces Py/Ag. La figure 2A représente la magnétorésistance d'une multicouche de composition substrat Si/SiO$_2$/(Ni$_{80}$Fe$_{20}$ 2,5 nm/Ag 1,1 nm)$_{20}$ brut de dépôt (courbe I), après recuit à 275°C pendant 20 minutes (courbe II) et à 290°C pendant 20 minutes (courbe III). Sur ces figures la magnétorésistance est représentée par $\frac{R(H)}{R(O)}$x100, ce qui correspond à

$$\left(\frac{\Delta R}{R} + 1\right).100.$$

On constate que l'amplitude de magnétorésistance a considérablement diminué sous l'effet de ces recuits. En comparaison, la figure 2B montre la magnétorésistance d'une multicouche de composition substrat Si/(Co 0,3 nm/Ni$_{80}$Fe$_{20}$ 1,9 nm/Co 0,3 nm/Ag 1,1 nm)$_{20}$ brut de dépôt (courbe I) et après différents recuits successifs (courbes II-V) à des températures croissantes pendant 20 minutes. On constate que, par rapport à l'état brut de dépôt (courbe I), la magnétorésistance a augmenté après recuit à 275°C (courbe V), tandis que le champ de saturation a diminué. On voit en effet qu'après recuit, la magnétorésistance n'évolue plus pour une valeur de champ (champ de saturation) plus faible. Au-delà de 275°C, et jusqu'à 310°C (courbe II : 310°C, courbe III : 300°C, courbe IV : 290°C), l'amplitude de magnétorésistance diminue légèrement mais sans s'effondrer comme dans le cas de la figure 2A (sans Co aux interfaces). Par ailleurs, comme le champ de saturation continue de diminuer au-delà de 275°C, les courbes $\frac{R(H)}{R(O)}$.100 entre 275°C et 310°C se superposent pratiquement jusqu'à des champs de l'ordre de 2/3 du champ à saturation. La comparaison des figures 2A et 2B montre donc l'augmentation de la stabilité des propriétés magnétorésistives du matériau au cours de recuits, au moins jusqu'à 300°C, apportée par l'adjonction de fines couches de Co aux interfaces Permalloy/Ag.

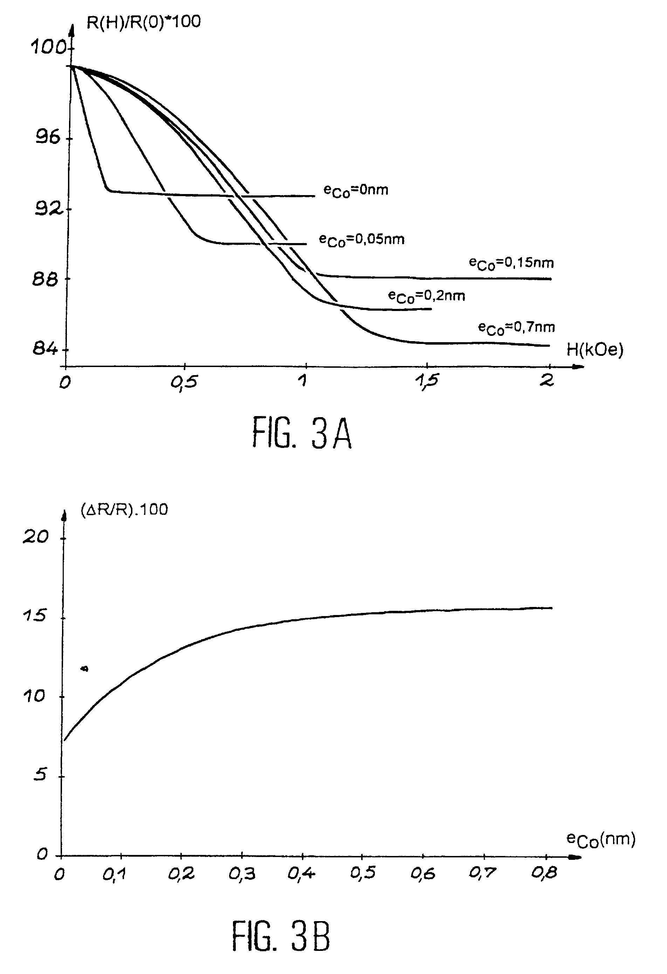

Corrélativement, l'adjonction de fines couches de Co aux interfaces Permalloy/Ag augmente l'amplitude de magnétorésistance du matériau. Ceci est illustré sur les figures 3A et 3B. La figure 3A représente un faisceau de courbes

$$\left(\frac{R(H)}{R(O)}\right)x100$$

obtenues pour différents échantillons correspondant à des épaisseurs $e_{Co}$ (en nm) croissantes des couches de Co interfaciales. Ces échantillons ont pour composition :
substrat Si/SiO$_2$/(Co $e_{Co}$/Ni$_{80}$Fe$_{20}$ (2,5-2$e_{Co}$) nm/Co $e_{Co}$/Ag 1,1 nm)$_{10}$.

Dans cette expérience, on a gardé l'épaisseur totale des couches magnétiques Co/NiFe/Co constante pour faciliter la comparaison d'un échantillon à l'autre. On constate, sur la figure 3A, une très rapide augmentation de l'amplitude de magnétorésistance lié à l'introduction des couches de Co interfaciales.

La figure 3B représente l'amplitude de magnétorésistance en fonction de l'épaisseur $e_{Co}$ des couches de Co. La courbe en trait plein est un ajustement suivant une loi phénoménologique exponentielle :

$$\frac{\Delta R}{R} = M_R = 7,2 + 8,5(1 - exp(-e_{Co} / 0,16)),$$

dans laquelle $e_{Co}$ est exprimée en nanomètres, et $M_R$ en %.

Cette courbe montre que l'amplitude de magnétorésistance augmente très vite aux faibles épaisseurs, pour pratiquement saturer lorsqu'une couche monoatomique de Co a été introduite aux interfaces. L'introduction d'un plan atomique de Co aux interfaces Permalloy/Ag suffit donc à doubler l'amplitude de magnétorésistance et à assurer une meilleure stabilité thermique de la structure.

Le champ de saturation, malheureusement, augmente également avec l'épaisseur des couches interfaciales de Co. Ceci est nettement visible sur la figure 3A. Le champ de saturation est tracé en fonction de l'épaisseur de Co sur la figure 3C. La courbe en trait plein représente la loi suivante :

$$H_{sat}(kOe)=0,156+1,15(1-exp(-e_{Co}/0,12)),$$

où $e_{Co}$ est exprimée en nanomètres, et $H_{sat}$ en kOe.

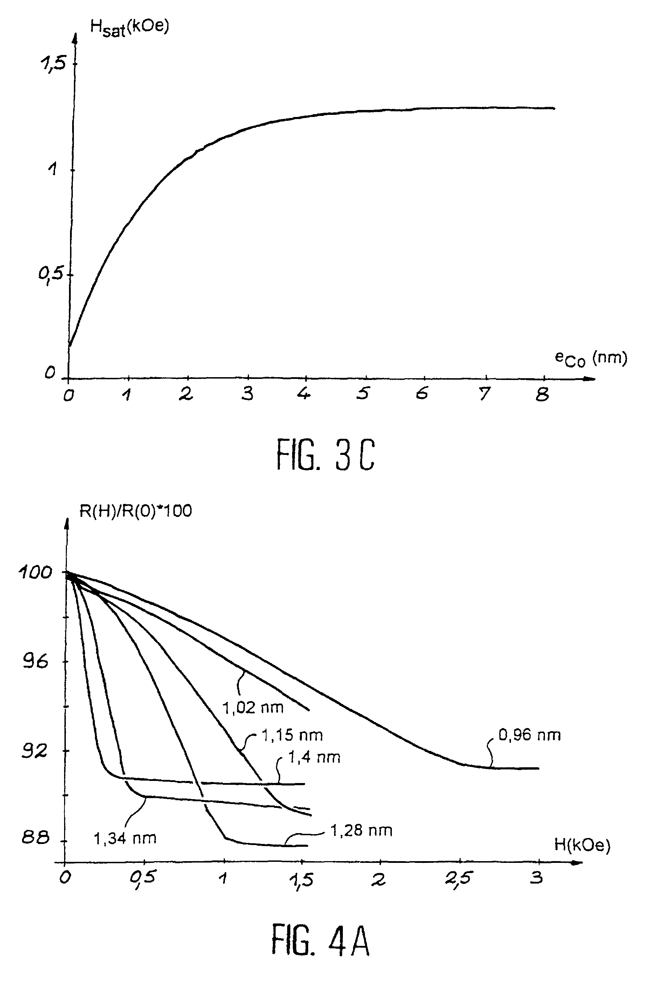

Le champ $H_{sat}$ augmente un peu moins rapidement que l'amplitude de magnétorésistance en fonction de l'épaisseur de Co. On peut néanmoins réduire ce champ de saturation en jouant sur l'épaisseur d'Ag. Ceci est illustré sur la figure 4A qui représente un faisceau de courbes $\frac{R(H)}{R(O)}$.100 obtenues pour différents échantillons correspondant à des épaisseurs $e_{Ag}$ croissantes des couches d'Ag. Ces échantillons ont pour composition :
substrat Si/(Co 0,2 nm/Ni$_{80}$Fe$_{20}$ 2,1 nm/Co 0,2 nm/Ag $e_{Ag}$)$_{10}$. Une très importante variation du champ de saturation est observée en fonction de l'épaisseur d'Ag. Le couplage entre couches de Permalloy avec Co aux interfaces à travers l'Ag est antiferromagnétique pour des épaisseurs d'Ag comprises entre environ 0,9 nm et 1,45 nm. Le champ de saturation est minimal vers l'extrémité supérieure de cette région d'épaisseur d'Ag, c'est-à-dire vers 1,3 à 1,4 nm d'Ag. Ceci est illustré sur la figure 4B, qui représente les variations du champ de saturation en fonction de l'épaisseur d'Ag. L'épaisseur préférentielle d'Ag à utiliser pour avoir la meilleure sensibilité possible $\Delta R/R(H)$ est donc de l'ordre de 1,3 à 1,4 nm.

Les résultats présentés dans le cadre de la présente demande sont surprenants, pour les raisons suivantes.

Il est tout d'abord connu dans les multicouches (Co/Ag) dans lesquelles les couches de Co sont très fines (de l'ordre de quelques plans atomiques d'épaisseur), qu'un recuit de ces structures conduit à une coalescence en îlots du Co. Les couches, initialement continues dans l'état brut de dépôt, se disloquent au cours des recuits. Le Co coalesce sous formes d'îlots, qui grossissent et deviennent de plus en plus distants les uns des autres au cours des recuits. Ce processus est décrit par exemple dans la publication de E.A.M. Van Alphen, P.A.A. Van der Heijden, W.L.M. de Jonge, Journal of Magnetism and Magnetic Materials 140-144 (1995) 609. Compte tenu de cet effet, l'homme de l'art ne serait pas enclin à mettre du Co aux interfaces NiFe/Ag car il pourrait craindre qu'une coalescence similaire se produise aux interfaces. Si tel était le cas, on aurait alors une interface discontinue constituée par endroit de NiFe/Ag, à d'autres endroits de NiFe/Co/Ag. Les endroits sans Co constitueraient des points de faiblesse pour la stabilité thermique des multicouches. Or, les résultats expérimentaux obtenus (comparaison des figures 2A, sans Co aux interfaces, et 2B avec Co aux interfaces) montrent que la stabilité thermique est bel et bien augmentée par l'introduction du Co aux interfaces. Ceci implique que la couche de Co introduite à l'interface peut être considérée comme continue, et donc que la coalescence du Co sous forme d'îlots est globalement négligeable ou nulle. Cette différence de comportement des fines couches de Co entre le système (Co/Ag) et celui avec les interfaces NiFe/Co/Ag est certainement due aux différences d'énergie interfaciale des interfaces NiFe/Co et Co/Ag.

Un autre problème qui aurait pu survenir au cours des recuits sur des multicouches Permalloy/Ag, avec Co aux interfaces, provient de la miscibilité du Permalloy et du Co. Les recuits effectués auraient pu conduire à une diffusion du Co à l'intérieur du Permalloy. Les interfaces se seraient alors progressivement appauvries en Co, ce qui aurait conduit à observer dans les multicouches Co/NiFe/Co/Ag les mêmes caractéristiques de stabilité thermique que dans des multicouches NiFe/Ag. Ce phénomène ne se produit pas ou très peu car, comme le montrent les figures 2A et 2B, la stabilité thermique du composé multicouche est augmentée par l'ajout de Co aux interfaces. Une certaine diffusion du Co dans le Permalloy doit effectivement se produire, mais doit rester suffisamment limitée pour ne pas complètement perdre le bénéfice sur la stabilité thermique.

Les structures données en exemple dans le présent document ont été préparées par pulvérisation cathodique. Le vide de base dans l'enceinte d'élaboration était de l'ordre de 2.10$^{-8}$ mbar. L'argon, à une pression de 1.5.10$^{-3}$ mbar, était utilisé comme gaz pour la pulvérisation. La cible de NiFe était alimentée par une source RF, les cibles de Co et d'Ag par des sources DC. Les substrats étaient refroidis, pendant les dépôts de ces matériaux, à une température proche de celle de l'azote liquide, pour éviter la coalescence des couches d'Ag. D'autres techniques d'élaboration des couches minces métalliques pourraient être utilisées pour la préparation de ces matériaux, telles que l'épitaxie par jet moléculaire ou la pulvérisation par faisceau d'ions.

Une structure magnétique selon l'invention peut être utilisée pour réaliser un capteur de courant tel que décrit dans la demande FR-2 710 753 (DD 1289).

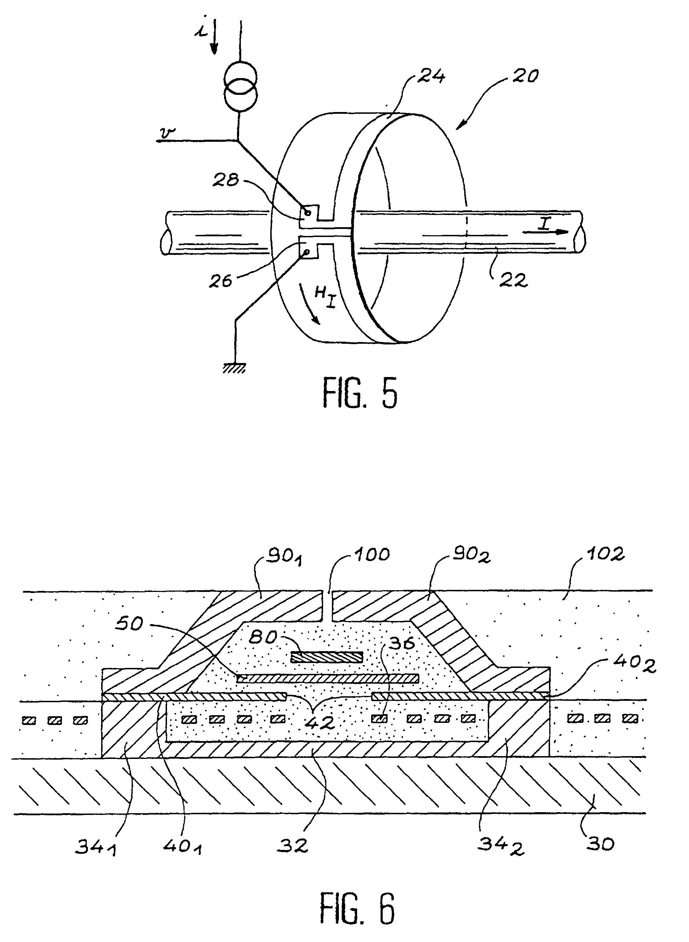

La figure 5 représente un tel capteur de courant 20, en position de mesure d'un courant I parcourant un conducteur électrique 22. Le capteur de courant 20 en forme d'anneau comporte un ruban magnétorésistif 24 également en forme d'anneau. Les extrémités 26 et 28 du ruban 24 sont disposées à proximité l'une de l'autre de façon que le ruban forme un cercle presque complet. Ces extrémités sont aménagées pour permettre la connexion électrique du ruban 24 avec un générateur de courant continu i (ou de tension). L'observation de la tension v aux bornes du ruban 24 permet de constater la variation de la résistance du ruban sous l'effet du champ magnétique $H_I$ induit par le courant I.

Ce même document décrit également un circuit électrique pour la mesure de I. Il décrit aussi un procédé de réalisation dudit capteur.

Une structure magnétique selon l'invention peut également être utilisée pour réaliser une tête magnétique.

La figure 6 montre, à titre illustratif, comment mettre en oeuvre l'invention dans une tête magnétique d'écriture et/ou de lecture. Une telle tête a été décrite dans la demande de brevet français n°93 13249 déposée le 8 novembre 1993.

La tête est représentée en coupe. On y voit un substrat 30, une couche magnétique inférieure 32, deux piliers magnétiques $34_1$, $34_2$, un bobinage conducteur 36, deux pièces magnétiques $40_1$, $40_2$ formant un premier entrefer 42, un élément magnétorésistant multicouche 50 placé au-dessus de l'entrefer 42, un conducteur de polarisation 80, traversé par un courant circulant perpendiculairement au plan de la figure, deux pièces polaires $90_1$, $90_2$ définissant un second entrefer 100, qui est l'entrefer défilant devant le support d'enregistrement magnétique (non représenté), le tout étant noyé dans un isolant 102.

Par réglage du courant circulant dans le conducteur 80, on polarisera la magnétorésistance 50 à une valeur appropriée.

D'une façon générale, le principal avantage apporté par l'invention est d'augmenter la stabilité des propriétés structurales du matériau au cours de recuit à des températures allant au moins de 250°C à 300°C, températures auxquelles le matériau peut être soumis lors des procédés lithographiques. Par ailleurs, l'adjonction de fines couches interfaciales de Co, ou d'alliages riches en Co, aux interfaces Permalloy/Ag permet d'augmenter l'amplitude de magnétorésistance ce qui, notamment dans les structures vanne de spin, conduit à une augmentation de la sensibilité du matériau (augmentation de ΔR/R sans augmentation significative de la variation de champ nécessaire à observer toute l'amplitude de magnétorésistance).

## Revendications

1.  Structure magnétique multicouches comportant un empilement alterné :

-  de couches (6, 16) d'un premier type, à base de matériau magnétiques, cette couche étant de formule :
   $Ni_{100-x-y-z}Co_xFe_yA_z$ où $0 \leq x < 30$, $0 \leq y \leq 100$ et $0 \leq z \leq 40$, et $0 \leq x+y+z \leq 100$, A désigne un seul élément ou plusieurs éléments tels que Cu, Cr, Mo, V, B,
-  de couches (12) d'un second type, en Ag ou en un alliage riche en Ag,
-  une couche interfaciale mince (8, 14) de Co ou d'un alliage riche en Co étant située aux interfaces des couches du premier type et des couches du second type.

2.  Structure magnétique selon la revendication 1, les couches d'un premier type étant à base de Permalloy.

3.  Structure magnétique selon l'une des revendications 1 ou 2, l'alliage riche en Ag étant de composition $Ag_xCu_{1-x}$ ou $Ag_xAu_{1-x}$ avec $0 < x < 0,5$.

4.  Structure selon l'une des revendications 1 à 3, chaque couche interfaciale ayant une épaisseur comprise entre une fraction de plan atomique et quelques plans atomiques.

5.  Structure magnétique multicouches selon l'une des revendications 1 à 4, l'épaisseur des couches du second type étant telle qu'un couplage antiferromagnétique existe entre les couches du premier type à travers les couches du second type et les couches interfaciales.

6.  Structure magnétique multicouches selon la revendication 5, l'épaisseur des couches du second type étant comprise entre 0,8 et 1,5 nm.

7.  Structure magnétique multicouches selon l'une des revendications 1 à 4 comportant deux couches du premier type et une couche du second type.

8.  Structure magnétique selon l'une des revendications 1 à 4 comportant trois couches du premier type et deux couches du second type.

9.  Structure magnétique multicouches selon la revendication 7 ou 8, la, ou les, couche(s) du second type ayant une épaisseur telle qu'il n'existe aucun, ou seulement un très faible, couplage antiferromagnétique entre les couches du premier type.

10.  Structure magnétique multicouches selon la revendication 9, la couche du second type ayant une épaisseur comprise entre 2 et 5 nm.

11.  Structure magnétique selon l'une des revendications 7 à 10, une couche antiferromagnétique étant déposée sur une des couches du premier type.

**12.** Structure magnétique selon la revendication 11, la couche antiferromagnétique étant en FeMn et d'épaisseur comprise entre 7 et 12 nm.

**13.** Procédé de réalisation d'une structure magnétique multicouches comportant les étapes de :

- dépôt de couches d'un premier type, à base de matériaux magnétiques, cette couche étant de formule :
  $Ni_{100-x-y-z}Co_xFe_yA_z$ où $0 \leq x < 30$, $0 \leq y \leq 160$ et $0 \leq z \leq 40$, et $0 \leq x+y+z \leq 100$, A désigne un seul élément ou plusieurs éléments tels que Cu, Cr, Mo, V, B,
- dépôt de couches d'un second type, en Ag ou en un alliage riche en Ag,
- formation d'une couche interfaciale mince de Co ou d'un alliage riche en Co aux interfaces des couches de premier et de second types.

**14.** Procédé selon la revendication 13, les différentes couches étant déposées par condensation de vapeurs métalliques sur un substrat, à une température inférieure à la température ambiante.

**15.** Procédé selon la revendication 14, les couches du premier, du second types et les couches interfaciales étant réalisées par pulvérisation cathodique.

**16.** Capteur multicouches à effet magnétorésistif comportant une structure magnétique en couche selon l'une des revendications 1 à 12.

**17.** Capteur de courant (20) destiné à mesurer le courant parcourant un conducteur électrique (22) comprenant un ruban magnétorésistif (24) entourant le conducteur et dont les extrémités (26, 28) sont destinées à être connectées à un dispositif de mesure du courant, le ruban étant constitué en structure magnétique en couche selon l'une des revendications 1 à 12.

**18.** Tête magnétique d'écriture et/ou de lecture comportant un élément magnétorésistant (50) en couche selon l'une des revendications 1 à 12.

**Claims**

**1.** Multilayered magnetic structure including alternate stack of:

- layers (6, 16) of a first type, based on magnetic materials, said layer being of formula $Ni_{100-x-y-z}Co_xFe_yA_z$ where $0 \leq x \leq 100$, $0 \leq y \leq 100$ and $0 \leq z \leq 40$ and $0 \leq x+y+z \leq 100$, A designating one or more elements such as Cu, Cr, Mo, V, B,
- layers (12) of a second type, made of Ag or an Ag-rich alloy,
- a thin interface layer (8, 14) of Co or a Co-rich alloy being located at the interfaces between layers of the first type and layers of the second type.

**2.** Magnetic structure according to claim 1, the layers of the first type being based on Permalloy.

**3.** Magnetic structure according to either of claims 1 or 2, the Ag-Rich alloy composition being $Ag_xCu_{1-x}$ or $Ag_xAu_{1-x}$ where $0 < x < 0.5$.

**4.** Structure according to any one of the claims 1 to 3, the thickness of each interface layer being between a fraction of an atomic plane and a few atomic planes.

**5.** Multilayered magnetic structure according to any one of the claims 1 to 4, the thickness of layers of the second type being such that there is an antiferromagnetic coupling between layers of the first type through layers of the second type and the interface layers.

**6.** Multilayered magnetic structure according to claim 5, the thickness of layers of the second type being between 0.8 and 1.5 nm.

**7.** Multilayered magnetic structure according to any one of the claims 1 to 4, including two layers of the first type and one layer of the second type.

**8.** Magnetic structure according to any one of the claims 1 or 4, comprising three layers of the first type and two layers of the second type.

**9.** Multilayered magnetic structure according to claim 7 or 8, the layer or layers of the second type having a thickness such that there is no, or only a very weak, antiferromagnetic coupling between the layers of the first type.

**10.** Multilayered magnetic structure according to claim 9, the layer of the second type having a thickness of between 2 and 5 nm.

**11.** Magnetic structure according to any one of the claims 7 to 10, an antiferromagnetic layer being deposited on one of the layers of the first type.

**12.** Magnetic structure according to claim 11, the antiferromagnetic layer being made of FeMn and with a thickness of between 7 and 12 nm.

**13.** Process for making a multilayered magnetic structure including the following steps:

- deposit layers of a first type, based on magnetic materials, said layer being of formula $Ni_{100-x-y-z}Co_xFe_yA_z$ where $0 \leq x \leq 30$, $0 \leq y \leq 100$ and $0 \leq z \leq 40$ and $0 \leq x+y+z \leq 100$, A designating one or more elements such as Cu, Cr, Mo, V, B,
- deposit layers of a second type, made of Ag or an Ag-rich alloy,
- formation of a thin interface layer of Co or a Co-rich alloy at interfaces between the first and second types of layers.

**14.** Process according to claim 13, the various layers being deposited by condensation of metal vapours on a substrate, at a temperature below the ambient temperature.

**15.** Process according to claim 14, the layers of the first and second types and the interface layers being made by cathodic spraying.

**16.** Multilayer sensor with magnetoresistive effect comprising a magnetic structure in layers according to any one of the claims 1 to 12.

**17.** Current sensor (20) designed to measure the current passing through an electric conductor (22) consisting of a magnetoresistive tape (24) surrounding the conductor and the ends (26, 28) of which are designed to be connected to a current measurement device, the tape being composed of a layered magnetic structure according to any one of the claims 1 to 12.

**18.** Magnetic write and/or read head comprising a layered magnetoresistant element (50) according to any one of the claims 1 to 12.

**Patentansprüche**

**1.** Magnetische Mehrschichtstruktur mit einem Stapel, der abwechselnd umfasst:

- Schichten (6, 16) eines ersten Typs auf der Basis magnetischer Materialien der folgenden Formel:
  $Ni_{100-x-y-z}Co_xFe_yA_z$, wobei $0 \leq x < 30$, $0 \leq y \leq 100$ und $0 \leq z \leq 40$, und $0 \leq x+y+z \leq 100$, und A ein einziges Element oder mehrere Elemente wie Cu, Cr, Mo, V, B bezeichnet,
- Schichten (12) eines zweiten Typs, aus Ag oder aus einer Ag-reichen Legierung,
- eine Grenz- bzw. Übergangsflächen-Dünnschicht (8, 14) aus Co oder einer Co-reichen Legierung, die sich an den Grenz- bzw. Übergangsflächen der Schichten des ersten Typs und der Schichten des zweiten Typs befindet.

**2.** Magnetische Struktur nach Anspruch 1, wobei die Schichten eines ersten Typs Schichten auf Permalloy-Basis sind.

**3.** Magnetische Struktur nach einem der Ansprüche 1 oder 2, wobei die Ag-reiche Legierung die Zusammensetzung $Ag_xGu_{1-x}$ oder $Ag_xAu_{1-x}$ mit $0<x<0,5$ hat.

**4.** Struktur nach einem der Ansprüche 1 bis 3, wobei jede Grenz- bzw. Übergangsflächenschicht eine Dicke hat, die zwischen einem Bruchteil einer atomaren Ebene und mehreren atomaren Ebenen enthalten ist.

**5.** Magnetische Mehrschichtstruktur nach einem der Ansprüche 1 bis 4, wobei die Dicke der Schichten des zweiten Typs so ist, dass zwischen den Schichten des ersten Typs eine antiferromatgnetische Kopplung existiert, durch die Schichten des zweiten Typs und die Grenz- bzw. Übergangsflächenschichten hindurch.

**6.** Magnetische Mehrschichtstruktur nach Anspruch 5, wobei die Dicke der Schichten des zweiten Typs zwischen 0,8 und 1,5 nm enthalten ist.

**7.** Magnetische Mehrschichtstruktur nach einem der Ansprüche 1 bis 4 mit zwei Schichten des ersten Typs und einer Schicht des zweiten Typs.

**8.** Magnetische Mehrschichtstruktur nach einem der Ansprüche 1 bis 4 mit drei Schichten des ersten Typs und zwei Schichten des zweiten Typs.

**9.** Magnetische Mehrschichtstruktur nach Anspruch 7 oder 8, wobei die Schicht(en) des zweiten Typs eine solche Dicke hat (haben), dass keine oder nur eine sehr schwache antiferromagnetische Kopplung zwischen den Schichten des ersten Typs existiert.

**10.** Magnetische Mehrschichtstruktur nach Anspruch 9, wobei die Schicht des zweiten Typs eine zwischen 2 und 5 nm enthaltene Dicke hat.

**11.** Magnetische Mehrschichtstruktur nach einem der Ansprüche 7 bis 10, wobei eine antiferromagnetische Schicht auf einer der Schichten des ersten Typs abgeschieden wird.

**12.** Magnetische Struktur nach Anspruch 11, wobei die antiferromagnetische Schicht aus FeMn ist und ihre Dicke zwischen 7 und 12 nm enthalten ist.

**13.** Verfahren zur Herstellung einer magnetischen Mehrschichtstruktur mit folgenden Schritten:

- Abscheiden von Schichten eines ersten Typs auf der Basis magnetischer Materialien der folgenden Formel:
  $Ni_{100-x-y-z}Co_xFe_yA_z$, wobei $0 \leq x < 30$, $0 \leq y \leq 160$ und $0 \leq z \leq 40$, und $0 \leq x+y+z \leq 100$, und A ein einziges Element oder mehrere Elemente wie Cu, Cr, Mo, V, B bezeichnet,
- Abscheiden von Schichten eines zweiten Typs, aus Ag oder aus einer Ag-reichen Legierung,
- Bilden einer Grenz- bzw. Übergangsflächendünnschicht aus Co oder einer Co-reichen Legierung an den Grenz- bzw. Übergangsflächen der Schichten des ersten Typs und des zweiten Typs.

**14.** Verfahren nach Anspruch 13, wobei die verschiedenen Schichten durch Kondensation von Metalldämpfen auf einem Substrat abgeschieden werden, dessen Temperatur niedriger ist als die Umgebungstemperatur.

**15.** Verfahren nach Anspruch 14, wobei die Schichten des ersten und des zweiten Typs und die Grenz- bzw. Übergangsflächenschichten durch Sputtern erzeugt werden.

**16.** Mehrschichtsensor mit magnetoresisitvem Effekt mit einer magnetischen Schichtstruktur nach einem der Ansprüche 1 bis 12.

**17.** Strom-Meßfühler (20) zum Messen des einen elektrischen Leiter (22) durchfließenden Stroms, einen magnetoresitiven Streifen (24) umfassend, der den Leiter umgibt und dessen Enden (26, 28) dazu bestimmt sind, mit einer Strommessvorrichtung verbunden zu werden, wobei der Streifen durch eine magnetische Schichtstruktur nach einem der Ansprüche 1 bis 12 gebildet wird.

**18.** Schreib- und/oder Lese-Magnetkopf mit einem magnetoresistiven Schichtelement (50) nach einem der Ansprüche 1 bis 12.

FIG. 1

FIG. 4 B

FIG. 2 A

FIG. 2B

FIG. 3A

FIG. 3B

FIG. 3 C

FIG. 4 A

FIG. 5

FIG. 6